# EUROPÄISCHE PATENTSCHRIFT

(11) **EP 1 430 568 B1**
(45) Veröffentlichungstag und Bekanntmachung des Hinweises auf die Patenterteilung: **31.08.2005**
(21) Anmeldenummer: 02772064.8
(22) Anmeldetag: 19.09.2002
(51) Int. Cl.: H01R 4/58

(54) **METALLISCHE OBERFLÄCHE EINES KÖRPERS, VERFAHREN ZUR HERSTELLUNG EINER STRUKTURIERTEN METALLISCHEN OBERFLÄCHE EINES KÖRPERS UND DESSEN VERWENDUNG**
METALLIC SURFACE OF A BODY, METHOD FOR PRODUCING A STRUCTURED METALLIC SURFACE OF A BODY AND THE USE THEREOF
SURFACE METALLIQUE D'UN CORPS, PROCEDE POUR PRODUIRE UNE SURFACE METALLIQUE STRUCTUREE D'UN CORPS ET SON UTILISATION

(30) Priorität: 19.09.2001 DE 10146274
(43) Veröffentlichungstag der Anmeldung: 23.06.2004
(73) Patentinhaber: ROBERT BOSCH GMBH, 70442 Stuttgart (DE); Mücklich, Frank, 66773 Schwalbach (DE)
(72) Erfinder: MÜCKLICH, Frank, 66773 Schwalbach (DE); SCHORR, Harald, 70563 Stuttgart (DE); REHBEIN, Peter, 71287 Weissach (DE)
(86) Internationale Anmeldenummer: PCT/DE2002/003503
(87) Internationale Veröffentlichungsnummer: WO 2003/028159

(56) Entgegenhaltungen:
- US-A- 6 040 067
- PATENT ABSTRACTS OF JAPAN vol. 1999, no. 02, 26. Februar 1999 (1999-02-26) & JP 10 302867 A (HARNESS SOGO GIJUTSU KENKYUSHO:KK;SUMITOMO WIRING SYST LTD; SUMITOMO E), 13. November 1998 (1998-11-13)

## Beschreibung

Die Erfindung betrifft eine metallische Oberfläche eines Körpers, insbesondere einen Kontaktbereich oder eine Oberfläche eines Steckers oder einer Steckverbindung, eines lösbaren, insbesondere lösbaren abhebenden oder lösbaren schiebenden elektrischen Kontaktelementes wie eines Relais oder eines Schalters, oder eines Elementes zur elektrischen Kontaktierung oder elektrischen Verbindung von Bauteilen, ein Verfahren zur Herstellung einer strukturierten metallischen Oberfläche eines Körpers sowie dessen Verwendung, nach der Gattung der unabhängigen Ansprüche.

### Stand der Technik

Als Oberflächen für elektrische Kontaktelemente bzw. Stecker kommen derzeit beispielsweise im Automobilbereich vorwiegend Zinnoberflächen zum Einsatz, d.h. feuerverzinnte Substrate oder Substrate mit einer galvanisch abgeschiedenen Zinnschicht im Bereich einer Dicke von wenigen Mikrometern. Zinn zeichnet sich dabei durch seine Duktilität sowie seine gute elektrische Leitfähigkeit aus.

Als Grundwerkstoff bzw. Substrat für elektrische Steckverbindungen bzw. Stecker mit einer oberflächlichen Zinnschicht dienen in der Regel Legierungen auf Basis von Kupfer, wie beispielsweise Bronze, so dass sich an der Grenzfläche zwischen der Zinnschicht und Substrat durch Diffusion eine Zwischenschicht ausbildet, die aus einer intermetallischen Verbindung, beispielsweise einer Verbindung der Zusammensetzung CuSn₃, Cu₅Sn₆, besteht. Diese ist härter als die darüber befindliche Zinnschicht und kann temperaturbedingt auch wachsen.

Schließlich ist bekannt, auf Steckern bzw. Steckkontakten eine Schicht aus sogenanntem "Thermozinn" aufzubringen, d.h. eine Schicht auf Basis von intermetallischen Phasen mit Zinn, die durch eine Warmauslagerung entstanden ist.

Aus der JP-A-10302867 ist ein wärmebehandelter Steckverbinder bekannt, bei dem die Oberfläche bereichsweise aus Zinn und Kupfer-Zinn-Legierung besteht. Die Bereiche aus Kupfer-Zinn-Legierung werden durch Spitzen gebildet, die aus einer Zinnschicht hervortreten. Gemäß der Lehre der Schrift resultiert daraus eine sehr raue und unregelmäßige Oberfläche des Steckverbinders.

Steckverbinder aus Legierungen mit Kupferanteilen werden auch i US-A-6,040,067 vorgeschlagen. Dabei ist vorgesehen, eine Kupfer legierung mit Zinn oder einer Zinnlegierung zu beschichten und durch Wärmebehandlung die Oberfläche in eine intermetallische Verbindung aus Cu-Sn oder Cu-Sn-Zn zu überführen. Die Dicke der Kupfer- bzw. der darauf aufgebrachten Zinnschicht beträgt bevor zugt weniger als 10 µm bzw. 0,5 bis 10 µm.

Zinnlegierungen neigen bekanntermaßen aufgrund ihrer geringen Härte bzw. ihres geringen Verschleißwiderstandes bei häufigem Stecken oder auch fahrzeug- bzw. motorbedingten Vibrationen leicht zum Durchrieb sowie zu einer verstärkten Oxidation (Reibkorrosion), was beispielsweise in einem Kraftfahrzeug zum Ausfall einer Komponente, insbesondere eines Sensors, eines Steuergerätes oder einer anderen elektrischen Komponente, führen kann.

Daneben ist bei bekannten Oberflächen von Steckverbindungen auf Zinnbasis nachteilig, dass die aufgrund der hohen Adhäsionsneigung und der plastischen Verformbarkeit von Zinn auftretenden Steckkräfte vielfach sehr hoch sind.

### Vorteile der Erfindung

Die erfindungsgemäße metallische Oberfläche eines Körpers und das erfindungsgemäße Verfahren zur Herstellung einer strukturierten metallischen Oberfläche eines Körpers hat gegenüber dem Stand der Technik den Vorteil, dass durch einen Wärmeeintrag in lokal definierte Bereiche der Oberfläche des metallischen Körpers, insbesondere über eine kurzzeitige Laserbehandlung, dort lokal vor allem über induzierte Diffusionsprozesse eine intermetallische Verbindung erzeugt wird, wodurch sich gleichzeitig auch das Gefüge des dort vorliegenden Metalles ändert, während in den zumindest weitgehend nicht dem Wärmeeintrag ausgesetzten Oberflächenbereichen die Bildung dieser intermetallische Verbindung zumindest weitgehend unterbleibt.

Dabei lässt sich je nach Einstellung des eingesetzten Lasers sowohl die Tiefe der Bildung der intermetallischen Verbindung als auch ihre laterale Ausdehnung auf mikroskopischer Ebene definiert einstellen. Weiter kann durch die Lasereinstellung auch die Abtragsmenge bzw. die Verdampfung im Bereich der Oberfläche des bestrahlten Körpers eingestellt werden, so dass darüber eine definierte Topographie der Oberfläche des lokal mit Laserlicht beaufschlagten Körpers entsteht.

Im Fall der metallischen Oberfläche eines elektrischen Kontaktelementes wie eines Steckkontaktes oder eines Steckers ist weiter vorteilhaft, dass die Dicke der sich durch das erfindungsgemäße Verfahren einstellenden intermetallischen Verbindung an der Oberfläche des Körpers im Wesentlichen in der gleichen Größenordnung wie die typische Dicke einer üblichen Zinnschicht auf einem Grundkörper, beispielsweise aus einem Material auf Basis von Kupfer, liegt.

Vorteilhafte Weiterbildungen der Erfindung ergeben sich aus den in den Unteransprüchen genannten Maßnahmen.

So ist besonders vorteilhaft, dass durch das erfindungsgemäße Verfahren eine metallische Oberfläche mit einer zunächst im Wesentlichen aus Zinn bestehenden oder zinnhaltigen Schicht auf beispielsweise einem Grundkörper aus Kupfer oder einem kupferhaltigen Material definiert bereichsweise mit einer intermetallischen Zinn-Kupfer-Verbindung versehen werden kann, wobei in diese intermetallische Zinn-Kupfer-Verbindung dann bereichsweise Oberflächenbereiche eingebettet oder eingelassen sind, die zumindest im Wesentlichen aus reinem Zinn bestehen bzw. gegenüber den Bereichen, in denen sich die intermetallische Zinn-Kupfer-Verbindung gebildet hat, zumindest weitgehend unverändert geblieben sind.

Die derart erzeugte Kombination einer bereichsweise oberflächlich vorliegenden relativ harten intermetallischen Phase und darin eingebetteten oder eingelassenen Oberflächenbereichen mit duktilem Restzinn mit hoher elektrischer Leitfähigkeit auf der Oberfläche des metallischen Körpers erfüllt in besonderer Weise die elektrischen Eigenschaften, die an verschleißresistente Metalloberflächen, insbesondere Zinnoberflächen, gestellt werden, und führt weiterhin im Fall der Verwendung als Steckkontakt bzw. Stecker zu besonders niedrigen Steckkräften.

Durch die über das erfindungsgemäße Verfahren erhaltene, vorzugsweise periodische Oberflächentopographie des metallischen Körpers, beispielsweise in Form einer hügelförmigen oder wellenförmigen Oberflächentopographie, ist weiter vorteilhaft, dass sich Mikrobewegungen eines derartigen Stekkers bzw. Steckkontaktes bei Vibrationsbeanspruchung deutlich vermindern.

Daneben ist in diesem Zusammenhang vorteilhaft, wenn die entstandenen Oberflächenbereiche ein insbesondere gitterähnliches und/oder periodisches Muster von in der intermetallischen Verbindung integrierten oder eingebetteten Inseln oder Bereichen oder ein Muster von in der intermetallischen Verbindung integrierten oder eingebetteten linienförmigen Kanälen oder eine Mischung dieser Muster bilden.

Zur definierten lokalen und mikroskopischen Erzeugung der gewünschten Bereiche mit der intermetallischen Verbindung bzw. der Oberflächenbereiche in der Oberfläche des metallischen Körpers wird vorteilhaft ein Hochleistungslaser mit ausreichender Kohärenzlänge und einer nachgeordneten Abbildungseinrichtung eingesetzt, so dass über eine Strahlteilung mehrere, beispielsweise zwei oder vier kohärente Teilstrahlen erzeugt werden können, die durch Interferenz lokal periodisch ausreichend hohe Laserintensitäten bereit stellen. Die Absorption der lokalen Laserintensitäten liefert dann lokal begrenzt die Energie für eine definierte intermetallische Phasenbildung und/oder ein lokales Aufschmelzen bis hin zum Verdampfen und somit die Bildung der gewünschten, insbesondere periodischen Oberflächentopographie.

Insbesondere können dabei durch eine unterschiedliche Anzahl von kohärenten Teilstrahlen bzw. unterschiedliche räumliche Interferenzwinkel zwischen den Teilstrahlen in sehr einfacher Weise beispielsweise periodische punkt- oder linienförmige Muster wie "Löcher" oder die erwähnten "Inseln" oder "Kanäle" oder auch andere, weitgehend beliebige Muster erzeugt oder herausstrukturiert werden, die auf einer periodischen Phasenanordnung und/oder einem periodischen Topographieeffekt beruhen.

Im Übrigen ist vorteilhaft, dass die erfindungsgemäßen metallischen Oberflächen des Körpers eine deutliche, durch Nano-Intender-Messungen bestätigte Härtesteigerung gegenüber dem Zustand vor einer Strukturierung mit dem erfindungsgemäßen Verfahren zeigen.

Durch den Einsatz von gepulsten Hochenergie-Lasern, beispielsweise Nd:YAG-Lasern, ist es vorteilhaft möglich, lokal eine so hohe Leistung zur Verfügung zu stellen, dass mit einem "Schuss" mit einer Dauer von lediglich einigen Nanosekunden eine Fläche von typischerweise 1 mm² bearbeitet werden kann, so dass das erfindungsgemäße Verfahren auch für die Serienfertigung geeignet ist.

### Zeichnung

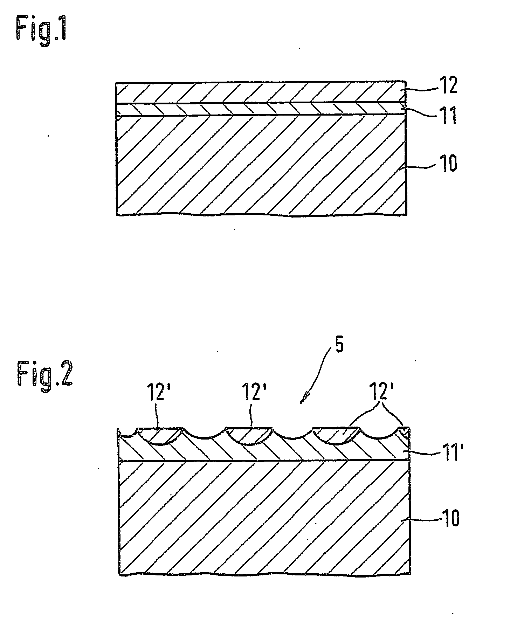

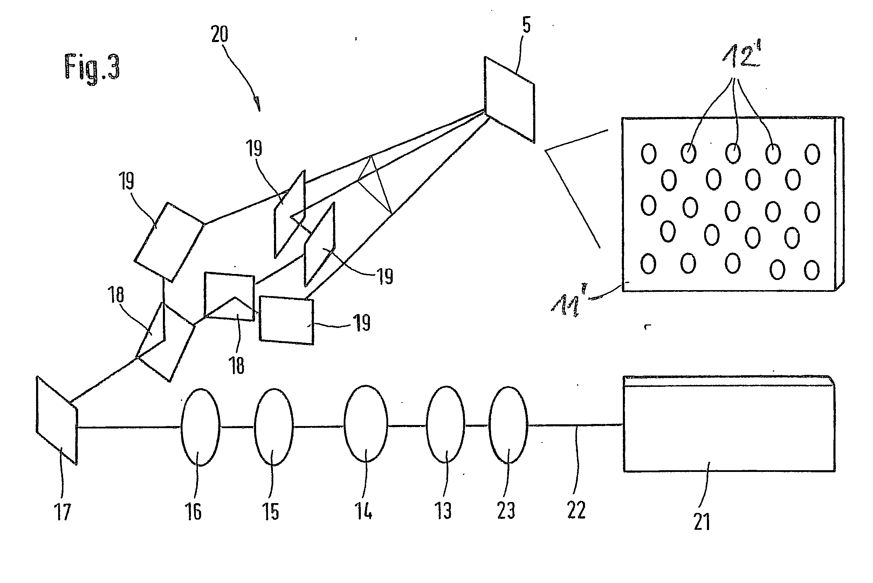

Die Erfindung wird anhand der Zeichnungen und in der nachfolgenden Beschreibung näher erläutert. Es zeigt Figur 1 eine Prinzipskizze eines Schnittes durch eine metallische Oberfläche eines Körpers vor Beaufschlagung mit dem erfindungsgemäßen Verfahren, Figur 2 die Oberfläche gemäß Figur 1 nach Beaufschlagung mit dem erfindungsgemäßen Verfahren als Prinzipskizze, und Figur 3 den Aufbau der Abbildungseinrichtung zur Beaufschlagung der Oberfläche eines Körpers im Rahmen eines Laser-Interferenz-Verfahrens.

### Ausführungsbeispiele

Die Figur 1 zeigt einen Grundkörper oder ein Substrat 10 aus einem weitgehend beliebigen Material, beispielsweise aus einem Metall wie Kupfer, Bronze, Messing, CuNiSi, einer Eisenlegierung oder einem insbesondere rostfreien Federstahl, auf dem sich eine erste intermetallische Schicht 11 befindet, die im erläuterten Beispiel aus einer Kupfer-Zinn-Legierung besteht. Auf der ersten intermetallischen Schicht 11 befindet sich weiter eine Metallschicht 12, die im erläuterten Beispiel eine Zinnschicht ist.

Die Figur 2 zeigt, wie nach Beaufschlagung der Oberfläche des Körpers gemäß Figur 1 im Rahmen eines Laser-Interferenz-Verfahrens mit Hilfe von Laserstrahlung und unter Verwendung einer Abbildungseinrichtung 20 gemäß Figur 3 im Bereich der metallischen Oberfläche 5 des beaufschlagten Körpers Oberflächenbereiche 12' entstanden sind, die zumindest weitgehend aus Zinn bestehen, und die im Wesentlichen in ihrer Zusammensetzung der Zinnschicht 12 gemäß Figur 1 entsprechen. In der Umgebung der Oberflächenbereiche 12' wurde demgegenüber durch die Beaufschlagung mit Laserstrahlung die erste intermetallische Schicht 11 und die Metallschicht 12 gemäß Figur 1 aufgeschmolzen oder allgemein zur Ermöglichung einer ausreichend großen Diffusion definiert wärmebehandelt, so dass sich daraus eine intermetallische Verbindung 11' gebildet hat, d.h. im erläuterten Beispiel eine Kupfer-Zinn-Legierung.

Die laterale Ausdehnung der Oberflächenbereiche 12' gemäß Figur 2 beträgt typischerweise 500 nm bis 50 µm, insbesondere 1 µm bis 20 µm, und sie weisen, ausgehend von der Oberfläche 5 des Körpers, eine typische Tiefe, von 100 nm bis hin zur Dicke der von der intermetallischen Verbindung 11' gebildeten Schicht 11', vorzugsweise 500 nm bis 5 µm, auf.

Die Dicke der von der intermetallischen Verbindung 11' gemäß Figur 2 gebildeten Schicht beträgt in der Regel mehr als 500 nm. Insbesondere liegt sie zwischen 1 µm und 20 µm, wobei ihre Dicke bevorzugt zumindest näherungsweise der Summe der Dicken der ersten intermetallischen Schicht 11 und der Metallschicht 12 entspricht.

Man.erkennt in Figur 2 im Schnitt deutlich, dass sich die Oberflächenbereiche 12' von der Oberfläche 5 des Körpers ausgehend in die intermetallische Verbindung 11' erstrecken und in diese eingebettet sind. Weiter ist erkennbar, dass die Oberflächenbereiche 12' in Form von Inseln ausgebildet sind, die in Draufsicht auf Figur 2 entweder regelmäßig oder unregelmäßig angeordnet sind und so ein Muster von Inseln bzw. auch linienförmigen Kanälen öder eine Mischung dieser Muster bilden. Diese Inseln können in der Tiefe bis hin zum Substrat 10 reichen.

Durch den lokalen Energieeintrag des Lasers ist es weiter, wie in Figur 2 angedeutet, lokal im Bereich der intermetallischen Verbindung 11' zu einer Verdampfung bzw. einer in der flüssigen Phase ausgebildeten Strukturierung gekommen, so dass die zuvor ebene Oberfläche 5 des Körpers gemäß Figur 2 nunmehr eine beispielsweise hügel- oder wellenförmige Topographie aufweist, die, je nach Anordnung der Oberflächenbereiche 12', bevorzugt periodisch ist. Die konkrete Ausgestaltung der erzielten Topographie unterliegt dabei kaum Beschränkungen und ist im Einzelfall ohne Weiteres an die gewünschte Verwendung anpassbar.

Im Übrigen ist klar, dass das erläuterte Verfahren sowohl zur Strukturierung von metallischen Oberflächen 5 als auch generell zur oberflächennahen Strukturierung oder Erzeugung metallischer Gefüge geeignet ist. Besonders geeignet ist es zur oberflächlichen Strukturierung von Kontaktflächen, insbesondere bei Steckern, elektrischen Kontaktelementen, lösbaren abhebenden elektrischen Kontaktelementen wie Relais, lösbaren schiebenden elektrischen Kontaktelementen wie Schaltern, oder sonstigen elektrischen Verbindungselementen. Weiter ist klar, dass sich die Oberflächenbereiche 12' abweichend von Figur 2 in der Tiefe auch bis hin zum Substrat 10 erstrecken können.

Im Übrigen sei noch betont, das neben den beispielhaft erläuterten Metallen Cu und Sn oder Legierungen oder intermetallischen Verbindungen mit diesen Metallen auch noch andere Metalle wie Ag, Ni, Fe, Ru, Zr, Au oder Al sowie Legierungen oder intermetallische Verbindungen mit diesen Metallen als Material für die erste intermetallische Schicht 11 oder die Metallschicht 12 in Frage kommen.

Weiter ist es in vielen Fällen zweckmäßig, wenn sich zwischen dem Substrat 10 und der ersten intermetallischen Schicht 11 noch mindestens eine weitere Zwischenschicht, beispielsweise eine Haftschicht, oder ein Multilagen-Schichtsystem befindet.

Die Figur 3 erläutert im Detail die Erzeugung der metallischen Oberfläche gemäß Figur 2 bzw. die Durchführung des erfindungsgemäßen Verfahrens am Beispiel einer metallischen Oberfläche 5, die zur Verdeutlichung in Draufsicht daneben noch einmal vergrößert dargestellt ist. Dort erkennt man deutlich in einer auf die Draufsicht auf Figur 2 entsprechenden Ansicht die periodische Anordnung der Oberflächenbereiche 12' in Form von Inseln in einer Schicht aus der intermetallischen Verbindung 11'. Im Einzelnen ist gemäß Figur 3 ein üblicher Nd:YAG-Laser vorgesehen, der bei einer Wellenlänge von beispielsweise 355 nm mit einer Leistung von 200 mW und einer Pulsdauer von 10 ns gepulst wird. Auf diese Weise entsteht eine Oberflächentopographie mit typischen Höhen bzw. Tiefen der Hügel oder Wellen im Bereich von 50 nm bis 500 nm.

Von dem Laser 21 gemäß Figur 3 geht ein Laserstrahl 22 aus, der über eine λ/2 -Platte 23 und einen nachgeschalteten Polarisator 13 zu einem mechanischen Shutter 14 gelangt, der eine Pulsung des Laserstrahles 22 bewirkt. Dem Shutter 14 sind zwei optische Abbildungslinsen 15, 16 nachgeordnet, die den Laserstrahl 22 über einen Umlenkspiegel 17 auf einen ersten Strahlteiler 18 abbilden, der den Laserstrahl 22 in einen ersten, einem Spiegel 19 zugeführten und einen zweiten, einem zweiten Strahlteiler 18 zugeführten Strahl aufteilt. Der zweite Strahl wird dann durch den zweiten Strahlteiler 18 erneut aufteilt, und einerseits einem Spiegel 19 und andererseits zwei weiteren Spiegeln 19 zugeführt. Insgesamt wird so der Laserstrahl 22 in drei auf die metallische Oberfläche 5 einwirkende Laserstrahlen aufgeteilt, die miteinander interferieren, so dass dort nach Art bekannter Laser-Interferenz-Verfahren ein lokal definierter Wärmeeintrag in die Oberfläche 5 erfolgt.

## Patentansprüche

1. Metallische Oberfläche eines Körpers, insbesondere Kontaktbereich oder Oberfläche eines Steckers oder einer Steckverbindung, eines lösbaren, insbesondere abhebenden oder schiebenden elektrischen Kontaktelementes oder eines Elementes zur elektrischen Kontaktierung oder Verbindung von Bauteilen, die bereichsweise eine intermetallische Verbindung (11') und bereichsweise Oberflächenbereiche (12') aufweist, die aus einem Metall oder einer von der intermetallischen Verbindung (11') verschiedenen Metalllegierung bestehen,
**dadurch gekennzeichnet,**
**dass** ein Substrat (10), insbesondere ein zumindest weitgehend aus Kupfer, Stahl oder einer Eisenlegierung bestehendes Substrat (10), vorgesehen ist, auf dem sich eine Schicht aus der intermetallischen Verbindung (11') befindet, in die die Oberflächenbereiche (12') eingebettet eingelassen sind.

2. Metallische Oberfläche eines Körpers nach Anspruch 1, **dadurch gekennzeichnet, dass** die intermetallische Verbindung (11') mindestens ein Metall ausgewählt aus der Gruppe Cu, Sn, Ag, Ni, Fe, Ru, Zr, Au oder A1 enthält oder eine Legierung oder intermetallische Verbindung mit einem oder mindestens zwei dieser Metalle ist.

3. Metallische Oberfläche eines Körpers nach Anspruch 2, **dadurch gekennzeichnet, dass** die intermetallische Verbindung (11')Zinn und Kupfer enthält, eine Legierung mit Zinn und Kupfer ist, oder zumindest im Wesentlichen aus Zinn und Kupfer besteht.

4. Metallische Oberfläche eines Körpers nach Anspruch 1, **dadurch gekennzeichnet, dass** die Schicht aus der intermetallischen Verbindung (11') eine Dicke von 500 nm bis 20 µm, insbesondere 1 µm bis 10 µm, aufweist.

5. Metallische Oberfläche eines Körpers nach einem der vorangehenden Ansprüche, **dadurch gekennzeichnet, dass** sich die Oberflächenbereiche (12') von der Oberfläche (5) des Körpers in die intermetallische Verbindung (11') erstrecken und/oder in diese eingebettet sind.

6. Metallische Oberfläche eines Körpers nach einem der vorangehenden Ansprüche, **dadurch gekennzeichnet, dass** die Oberflächenbereiche (12') ein insbesondere gitterähnliches Muster von in der intermetallischen Verbindung (11') integrierten oder eingebetteten Inseln oder Bereichen oder ein Muster von in der intermetallischen Verbindung (11') integrierten oder eingebetteten linienförmigen Kanälen oder eine Mischung dieser Muster bilden.

7. Metallische Oberfläche eines Körpers nach einem der vorangehenden Ansprüche, **dadurch gekennzeichnet, dass** die Oberflächenbereiche (12'), insbesondere im Fall der Inseln oder Bereichen, eine laterale Ausdehnung von 500 nm bis 50 µm, insbesondere von 1 µm bis 20 µm, und/oder im Fall der linienförmigen Kanäle eine Breite von 100 nm bis 100 µm, insbesondere von 10 µm bis 50 µm, aufweisen.

8. Metallische Oberfläche eines Körpers nach einem der vorangehenden Ansprüche, **dadurch gekennzeichnet, dass** die Oberflächenbereiche (12') sich ausgehend von der Oberfläche (5) des Körpers bis in eine Tiefe von 100 nm bis 20 µm, insbesondere von 500 nm bis 5 µm, in der intermetallischen Verbindung (11') erstrecken.

9. Metallische Oberfläche eines Körpers nach einem der vorangehenden Ansprüche, **dadurch gekennzeichnet, dass** die Oberfläche (5) eine Topographie, insbesondere eine hügel- oder wellenförmige Topographie aufweist.

10. Verfahren zur Herstellung einer strukturierten metallischen Oberfläche eines Körpers, insbesondere nach einem der vorangehenden Ansprüche, wobei zunächst auf einer ersten Metallschicht oder einer ersten intermetallischen Schicht (11) eine davon verschiedene zweite Metallschicht (12) oder zweite intermetallische Schicht erzeugt wird, und wobei danach zumindest die zweite Metallschicht (12) oder die zweite intermetallische Schicht derart bereichsweise aufgeheizt wird, dass sich dort mit dem Material der ersten intermetallischen Schicht (11) oder der ersten Metallschicht und dem Material der zweiten Metallschicht (12) oder der zweiten intermetallischen Schicht eine intermetallische Verbindung (11') bildet, in die Oberflächenbereiche (12') eingelassen oder eingebettet sind, die zumindest im Wesentlichen aus dem Material der zweiten Metallschicht (12) oder der zweiten intermetallischen Schicht bestehen.

11. Verfahren nach Anspruch 10, **dadurch gekennzeichnet, dass** das Aufheizen mit Hilfe einer optischen Abbildungseinrichtung (20) erfolgt, mit der Laserlicht hoher Intensität kurzzeitig auf definierte Bereiche der metallischen Oberfläche (5) abgebildet wird, wobei in den dem Laserlicht ausgesetzten Bereichen der metallischen Oberfläche (5) die intermetallische Verbindung (11') entsteht.

12. Verfahren nach Anspruch 10 oder 11, **dadurch gekennzeichnet, dass** die Oberflächenbereiche (12') gegenüber den benachbarten, von der intermetallischen Verbindung (11') eingenommenen Bereichen vergleichsweise wenig oder nicht aufgeheizt werden.

13. Verfahren nach einem der Ansprüche 10 bis 12, **dadurch gekennzeichnet, dass** ein definiertes lokales Aufheizen der metallischen Oberfläche (5) mit der Abbildungseinheit mit Hilfe eines Laser-Interferenz-Verfahrens erfolgt.

14. Verfahren nach einem der Ansprüche 10 bis 13, **dadurch gekennzeichnet, dass** durch das bereichsweise Aufheizen der metallischen Oberfläche (5) dort die Ausbildung einer Topographie, insbesondere einer periodischen hügel- oder wellenförmigen Topographie, induziert wird.

15. Verwendung des Verfahrens nach einem der vorangehenden Ansprüche zur Strukturierung von insbesondere metallischen Oberflächen (5) oder zur oberflächennahen Strukturierung oder Erzeugung metallischer Gefüge.

## Claims

1. Metallic surface of a body, in particular contact region or surface of a plug or plug connection, of a releasable, in particular lifting or sliding electrical contact element, or of an element for electrical contact-making or connection between components, which in regions comprises an intermetallic compound (11') and in regions comprises surface regions (12') which consist of a metal or a metal alloy other than the intermetallic compound (11'), **characterized in that** a substrate (10), in particular a substrate (10) which at least substantially comprises copper, steel or an iron alloy, on which substrate there is a layer of the intermetallic compound (11'), in which the surface regions (12') are embedded.

2. Metallic surface of a body according to Claim 1, **characterized in that** the intermetallic compound (11') contains at least one metal selected from the group consisting of Cu, Sn, Ag, Ni, Fe, Ru, Zr, Au or Al or is an alloy or intermetallic compound comprising one or at least two of these metals.

3. Metallic surface of a body according to Claim 2, **characterized in that** the intermetallic compound (11') contains tin and copper, is an alloy comprising tin and copper, or at least substantially comprises tin and copper.

4. Metallic surface of a body according to Claim 1, **characterized in that** the layer of the intermetallic compound (11') is from 500 nm to 20 µm, in particular 1 µm to 10 µm, thick.

5. Metallic surface of a body according to one of the preceding claims, **characterized in that** the surface regions (12') extend from the surface (5) of the body into the intermetallic compound (11') and/or are embedded in the latter.

6. Metallic surface of a body according to one of the preceding claims, **characterized in that** the surface regions (12') form in particular a gridlike pattern of islands or regions embedded or integrated in the intermetallic compound (11') or form a pattern of linear channels embedded or integrated in the intermetallic compound (11') or a mixture of these patterns.

7. Metallic surface of a body according to one of the preceding claims, **characterized in that** the surface regions (12'), in particular in the case of the islands or regions, have a lateral extent of from 500 nm to 50 µm, in particular from 1 µm to 20 µm, and/or, in the case of the linear channels, have a width of from 100 nm to 100 µm, in particular from 10 µm to 50 µm.

8. Metallic surface of a body according to one of the preceding claims, **characterized in that** the surface regions (12'), starting from the surface (5) of the body, extend down to a depth of 100 nm to 20 µm, in particular from 500 nm to 5 µm, in the intermetallic compound (11').

9. Metallic surface of a body according to one of the preceding claims, **characterized in that** the surface (5) has a topography, in particular a hill-like or wave-like topography.

10. Process for producing a structured metallic surface of a body, in particular according to one of the preceding claims, in which first of all a second metal layer (12) or second intermetallic layer is produced on a first metal layer or a first intermetallic layer (11), which is different from the second metal layer or second intermetallic layer, and in which then at least the second metal layer (12) or the second intermetallic layer is heated in regions, in such a manner that an intermetallic compound (11') is formed there comprising the material of the first intermetallic layer (11) or the first metal layer and the material of the second metal layer (12) or the second intermetallic layer, with surface regions (12'), which at least substantially comprise the material of the second metal layer (12) or the second intermetallic layer recessed or embedded in the intermetallic compound (11').

11. Process according to Claim 10, **characterized in that** the heating is carried out with the aid of an optical imaging device (20), which briefly images high-intensity laser light onto defined regions of the metallic surface (5), with the intermetallic compound (11') being formed in those regions of the metallic surface (5) which are exposed to the laser light.

12. Process according to Claim 10 or 11, **characterized in that** the surface regions (12') are heated relatively little or not at all compared to the adjacent regions taken up by the intermetallic compound (11').

13. Process according to one of Claims 10 to 12, **characterized in that** defined local heating of the metallic surface (5) is carried out by means of the imaging unit with the aid of a laser interference method.

14. Process according to one of Claims 10 to 13, **characterized in that** the heating of the metallic surface (5) in regions induces the formation of a topography, in particular a periodic hill-like or wave-like topography, in those regions.

15. Use of the process according to one of the preceding claims for structuring in particular metallic surfaces (5) or for structuring or production of metallic microstructures close to the surface.

## Revendications

1. Surface métallique d'un corps, en particulier zone de contact ou surface d'une fiche ou d'un raccordement par fiches, d'un élément de contact électrique amovible, notamment décollant ou coulissant, ou d'un élément pour la mise en contact ou la connexion de composants, qui présente par zones une combinaison intermétallique (11') et par zones des parties de surface (12') en métal ou en alliage de métal différent de la combinaison intermétallique (11'),
**caractérisée en ce qu'**
un substrat (10), en particulier un substrat (10) réalisé du moins en grande partie en cuivre, en acier ou en alliage de fer, comporte une couche de la combinaison intermétallique (11'), couche dans laquelle sont incrustées les parties de surface (12').

2. Surface métallique d'un corps selon la revendication 1,
**caractérisée en ce que**
la combinaison intermétallique (11') contient au moins un métal choisi dans le groupe Cu, Sn, Ag, Ni, Fe, Ru, Zr, Au ou Al ou un alliage ou une combinaison intermétallique avec un ou au moins deux de ces métaux.

3. Surface métallique d'un corps selon la revendication 2,
**caractérisée en ce que**
la combinaison intermétallique (11') contient de l'étain ou du cuivre, est un alliage avec de l'étain et du cuivre ou est réalisée du moins pour l'essentiel en étain et en cuivre.

4. Surface métallique d'un corps selon la revendication 1,
**caractérisée en ce que**
la couche de la combinaison intermétallique (11') présente une épaisseur de 500 nm à 20 µm, notamment de 1 µm à 10 µm.

5. Surface métallique d'un corps selon l'une quelconque des revendications précédentes,
**caractérisée en ce que**
les parties de surface (12') de la surface (5) du corps s'étendent dans la combinaison intermétallique (11') et/ou sont incrustées dans celle-ci.

6. Surface métallique d'un corps selon l'une quelconque des revendications précédentes,
**caractérisée en ce que**
les parties de surface (12') forment une trame similaire à un réseau d'îlots ou de zones intégrés ou incrustés dans la combinaison intermétallique (11'), ou une trame de canaux linéaires intégrés ou incrustés dans la combinaison intermétallique (11') ou un mélange de ces trames.

7. Surface métallique d'un corps selon l'une quelconque des revendications précédentes,
**caractérisée en ce que**
les parties de surface (12'), notamment dans le cas des îlots ou des zones, présentent une étendue latérale de 500 nm à 50 µm, en particulier de 1 µm à 20 µm, et/ou dans le cas des canaux linéaires une largeur de 100 nm à 100 µm, en particulier de 10 µm à 50 µm.

8. Surface métallique d'un corps selon l'une quelconque des revendications précédentes,
**caractérisée en ce que**
les parties de surface (12') s'étendent à partir de la surface (5) du corps jusqu'à une profondeur de 100 nm à 20 µm, en particulier de 500 nm à 5µm, dans la combinaison intermétallique (11').

9. Surface métallique d'un corps selon l'une quelconque des revendications précédentes,
**caractérisée en ce que**
la surface (5) présente une topographie, notamment une topographie bosselée ou ondulée.

10. Procédé de fabrication d'une surface métallique structurée d'un corps, en particulier selon l'une quelconque des revendications précédentes, selon lequel on produit d'abord sur une première couche métallique ou une première couche intermétallique (11) une deuxième couche métallique (12) ou deuxième couche intermétallique différente de celle-ci, et on chauffe ensuite au moins la deuxième couche métallique (12) ou la deuxième couche intermétallique par zones de telle sorte qu'alors avec le matériau de la première couche intermétallique (11) ou de la première couche métallique et le matériau de la deuxième couche métallique (12) ou de la deuxième couche intermétallique, on forme une combinaison intermétallique (11'), dans laquelle sont insérées ou incrustées les parties de surface (12') qui du moins pour l'essentiel sont constituées du matériau de la deuxième couche métallique (12) ou de la deuxième couche intermétallique.

11. Procédé selon la revendication 10,
**caractérisé en ce que**
le chauffage est effectué à l'aide d'un dispositif de reproduction optique (20) qui projette une lumière laser à haute intensité pendant une courte durée sur des parties définies de la surface métallique (5), la combinaison intermétallique (11') se formant dans les parties de la surface métallique (5) exposées à la lumière laser.

12. Procédé selon la revendication 10 ou 11,
**caractérisé en ce que**
les parties de surface (12') sont chauffées relativement peu ou pas du tout par rapport aux parties voisines occupées par la combinaison intermétallique (11').

13. Procédé selon l'une quelconque des revendications 10 à 12,
**caractérisé en ce qu'**
un chauffage local défini de la surface métallique (5) avec l'unité de reproduction est effectué à l'aide d'un procédé d'interférence laser.

14. Procédé selon l'une quelconque des revendications 10 à 13,
**caractérisé en ce que**
le chauffage par zones de la surface métallique (5) y induit la formation d'une topographie, en particulier d'une topographie périodique montueuse ou ondulée.

15. Utilisation du procédé selon l'une quelconque des revendications précédentes, pour une structuration de surfaces (5) en particulier métalliques ou pour une structuration proche des surfaces ou pour l'obtention de structures métalliques.
